# DEMANDE DE BREVET EUROPEEN

(11) **EP 0 558 359 A1**
(43) Date de publication de la demande: **01.09.1993**
(21) Numéro de dépôt: 93400183.5
(22) Date de dépôt: 26.01.1993
(51) Int. Cl.: H05K 7/12

(54) **Dispositif de fixation d'un composant électronique contre une paroi d'un dissipateur thermique**

(30) Priorité: 28.01.1992 FR 9200871
(71) Demandeur: ALCATEL CONVERTERS, F-75008 Paris (FR)
(72) Inventeur: Boitard, Pierre-Yves, F-10300 Ste Savine (FR); Furier, Bernard, F-10270 Laubressel (FR)
(74) Mandataire: Pothet, Jean Rémy Emile Ludovic

(57) **Abrégé**

Le dispositif de fixation d'un composant électronique (10) contre une première paroi (11) d'un dissipateur thermique (12) est du type comprenant un élément de fixation (30) constitué par :
- une branche d'extrémité engagée dans un logement (81) réalisé dans une seconde paroi (82) du dissipateur thermique (12);
- une section d'appui opposée à la branche d'extrémité et destinée à venir en appui contre la face avant du composant (10), la section d'appui étant reliée à la branche d'extrémité par une section d'élasticité de façon telle que s'exerce une poussée sur la face avant du composant (10),

et est caractérisé en ce que la branche d'extrémité peut s'engager sensiblement librement dans le logement (81) selon une direction perpendiculaire à la seconde paroi (82) et est maintenue par arc-boutement dans ce logement (81) lorsque la section d'appui applique le composant (10) contre la première paroi (11).

## Description

Le domaine de l'invention est celui des dispositifs de fixation de composants électroniques contre des dissipateurs thermiques.

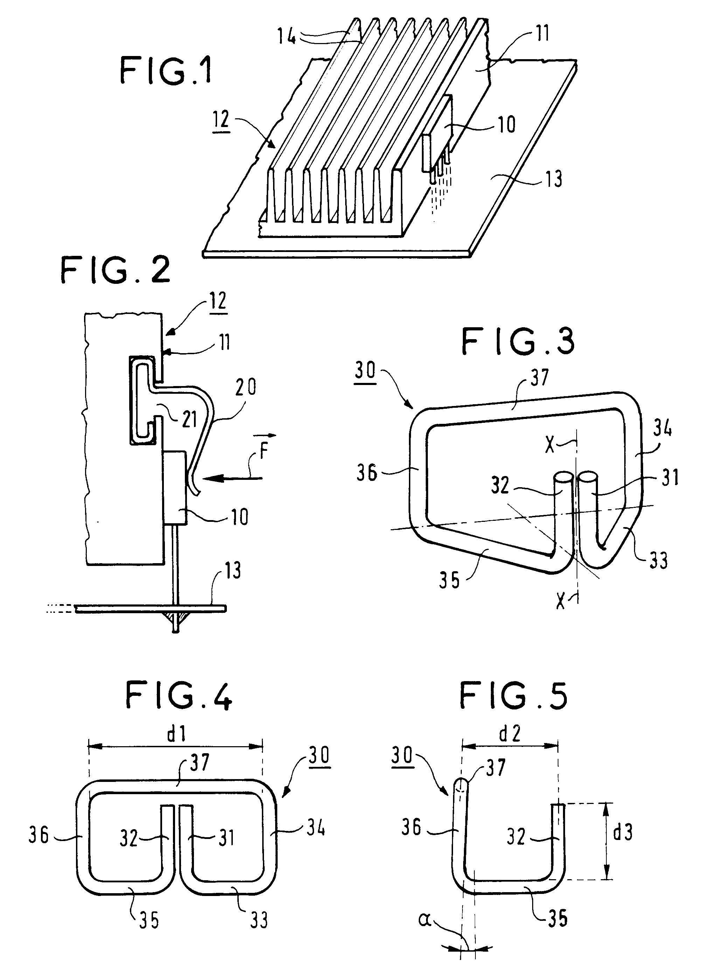

De façon connue, certains composants électroniques, notamment de type actif, dégagent une importante énergie calorifique lorsqu'ils fonctionnent à des puissances importantes. Afin d'évacuer la chaleur dissipée par ces composants et de prolonger ainsi leur durée de vie, ces composants coopèrent habituellement avec des dissipateurs thermiques destinés à dissiper l'énergie calorifique dégagée par ces composants. Le siège de cette énergie calorifique est généralement localisé au niveau des puces des composants actifs et les boîtiers des composants, habituellement métalliques, ne suffisent pas pour évacuer toute l'énergie thermique. C'est pourquoi on réalise un contact thermique entre les composants électroniques à refroidir et une paroi d'un dissipateur thermique, également appelé radiateur. La figure 1 représente un tel dissipateur thermique contre lequel est fixé un composant électronique.

Sur cette figure, un composant 10 est appliqué contre une paroi latérale 11 d'un dissipateur thermique 12. Le composant 10 est par exemple un transistor de puissance et ses trois broches de connexion sont soudées sur un circuit imprimé 13. Le dissipateur 12 est également fixé sur le circuit imprimé 13 par des moyens non représentés. Ce dissipateur 12 est constitué d'un profilé en alliage d'aluminium et présente une pluralité d'ailettes 14 de dissipation de l'énergie calorifique dégagée par le composant 10.

Une bonne dissipation calorifique du composant électronique est obtenue si le moyen de fixation du composant 10 sur la paroi 11 assure une pression suffisante du composant sur la paroi. Cette pression a pour fonction de réaliser un bon contact thermique entre la paroi et le composant et son intensité conditionne la qualité du couplage thermique entre le boîtier du composant et le dissipateur. De plus, dans de nombreuses applications, il est nécessaire d'isoler électriquement le composant 10 du dissipateur 12, afin d'éviter des courts-circuits électriques entre différents boîtiers métalliques de composants n'étant pas au même potentiel et entre le dissipateur lui-même et le composant 10.

Différents moyens de fixation du composant contre le dissipateur peuvent être mis en oeuvre et le composant 10 peut notamment être fixé à l'aide d'une vis contre une face latérale du dissipateur thermique. Cette technique largement employée fait également appel à une cale isolante traversant un logement réalisé dans le composant 10, cette cale isolante évitant un contact électrique entre l'orifice, généralement métallique, et le dissipateur, à travers la vis. Une feuille isolante, par exemple en mica, est placée entre le composant et le dissipateur. Le principal inconvénient de ce procédé de fixation est qu'il est délicat à mettre en oeuvre lorsque les distances d'isolement requises entre le composant et le dissipateur sont importantes.

De plus, cette méthode implique un usinage du dissipateur (perçage d'un logement) dans une direction perpendiculaire à des usinages déjà réalisés dans le dissipateur pour sa fixation sur le circuit imprimé. Ces derniers usinages permettent par exemple de monter le dissipateur sur des colonnettes verticales. Il est en effet gênant de devoir réaliser des usinages selon des axes différents puisqu'il est nécessaire d'effectuer une opération de pivotement du dissipateur, notamment lorsque les machines d'usinage (machines à commande numérique programmées) sont dotées de possibilités d'usinage réduites, par exemple dans une seule direction.

Il est néanmoins possible de ne réaliser des usinages que dans une seule direction à partir du moment où le composant peut être fixé sous le dissipateur. Les pattes du composant doivent alors être pliées à 90° pour être soudées sur le circuit imprimé et le montage de l'ensemble se complique alors de façon importante. De plus, l'usinage de l'orifice destiné à la fixation d'un composant à l'aide d'une vis doit consister en la réalisation d'un taraudage, coûteux en temps, à moins d'utiliser un écrou et un contre-écrou coopérant avec la vis. Le montage d'un composant sur le dissipateur est alors plus complexe et requiert également un temps important. Enfin, cette technique est réservée aux composants électroniques présentant un logement de passage d'une vis et ne peut donc être appliqué à tout type de composants à refroidir;

Une autre solution est d'appliquer le composant contre une paroi du dissipateur à l'aide d'un clip de fixation, comme représenté à la figure 2. Cette figure est une vue de côté d'un clip 20 de fixation dont l'extrémité supérieure est maintenue dans une découpe 21 réalisée dans la paroi latérale 11 du dissipateur 12. Cette découpe 21, réalisée lors de l'extrusion du profilé ou par usinage, est de forme sensiblement rectangulaire et présente une ouverture vers la paroi latérale 11 destinée au passage du corps du clip 20. Le corps du clip 20 présente une certaine élasticité lui conférant un rôle de ressort permettant d'appliquer une force 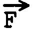 au composant 10. L'extrémité inférieure du clip 20 est ainsi en appui contre la face avant du composant 10. Une feuille de matériau isolant, par exemple en mica, peut être insérée entre la face arrière du composant 10 et la face avant 11 du dissipateur 12.

Ce mode de réalisation présente l'avantage d'être applicable à tout composant à refroidir à l'aide d'un dissipateur puisqu'aucun orifice n'est nécessaire dans ce composant. Le composant peut notamment présenter des formes diverses.

Cependant, l'usinage de la découpe 21 est complexe à réaliser et donc coûteux et il en va de même du clip de fixation 20. De plus, cet usinage est relativement important et, par conséquent, entraîne un enlèvement important de matière. On diminue de ce fait les qualités d'évacuation calorifique du dissipateur thermique. Par ailleurs, le montage du clip 20 ne peut se faire qu'en l'engageant dans l'une des extrémités de la découpe 21 et d'autres clips, servant à la fixation d'autres composants, peuvent se trouver sur son chemin de passage. Enfin, pour obtenir la découpe 21, il convient de particulariser le dessin du dissipateur, ce qui empêche l'utilisation de bien des dissipateurs standards du commerce.

La présente invention a notamment pour objectif de pallier ces inconvénients.

Plus précisément, un des objectifs de l'invention est de fournir un dispositif de fixation d'un composant électronique contre une paroi de dissipateur thermique, ce dispositif de fixation assurant un contact thermique optimal entre le composant et le dissipateur tout en présentant une structure simple, peu coûteuse et très facilement adaptable au dissipateur. Le dispositif de fixation a donc pour objectif d'assurer une pression plaquant le composant contre le dissipateur pour favoriser le transfert de chaleur.

Un autre objectif de l'invention est de fournir un tel dispositif de fixation ne nécessitant qu'un usinage réduit du dissipateur.

Ces objectifs, ainsi que d'autres qui apparaîtront par la suite, sont atteints grâce à un dispositif de fixation d'un composant électronique contre une première paroi d'un dissipateur thermique, du type comprenant un élément de fixation constitué par :
- au moins une branche d'extrémité engagée dans au moins un logement réalisé dans une seconde paroi du dissipateur thermique, à proximité du composant;
- une section d'appui opposée à la branche d'extrémité au moins et destinée à venir en appui contre la face avant du composant dont la face arrière est plaquée contre la première paroi, la section d'appui étant reliée à la branche d'extrémité au moins par une section d'élasticité de façon telle que s'exerce une poussée sur la face avant du composant pour appliquer le composant contre la première paroi,

ce dispositif étant caractérisé en ce que la branche d'extrémité au moins peut s'engager sensiblement librement dans le logement selon une direction perpendiculaire à la seconde paroi et est maintenue par arc-boutement dans le logement lorsque la section d'appui applique le composant contre la première paroi.

Le dispositif de fixation de l'invention fait donc appel à un élément de fixation qui assure l'application d'un composant contre une paroi d'un dissipateur par arc-boutement de ses extrémités dans un ou plusieurs logements.

Avantageusement, chacun des logements est constitué par un trou percé dans la seconde paroi. Les logements sont donc très facilement réalisables, par simple perçage du dissipateur.

Dans un mode de réalisation avantageux, la seconde paroi est la paroi constituant le dessous du dissipateur thermique, la première paroi étant une des parois latérales du dissipateur thermique, la seconde paroi comportant des alésages de fixation destinés à permettre la fixation du dissipateur sur un circuit imprimé, les alésages de fixation étant réalisés selon une direction de perçage parallèle à celle des logements.

Il n'est dans ce cas pas nécessaire de faire pivoter le dissipateur thermique lors de son perçage.

Préférentiellement, les logements sont réalisés dans la première paroi.

L'élément de fixation peut être constitué par un fil d'acier à ressort, la partie située au centre du fil d'acier à ressort constituant la section d'appui.

Ce fil d'acier à ressort peut être de section circulaire. La fabrication de l'élément de fixation est dans ce cas très simple puisqu'elle consiste à plier un fil d'acier.

Dans un autre mode de réalisation, le logement est unique, de forme sensiblement parallélépipédique et réalisé dans la seconde paroi, l'élément de fixation étant constitué par une lame ressort dont une extrémité pénètre dans le logement sensiblement parallélépipédique.

Avantageusement, le composant électronique est engagé dans une gaine électriquement isolante et thermiquement conductrice avant son application contre la première paroi par l'élément de fixation.

D'autres caractéristiques et avantages de l'invention apparaîtront à la lecture de la description suivante de deux modes de réalisation préférentiels, donnés à titre illustratif et non limitatif, et des dessins annexés dans lesquels:
- la figure 1 est une vue en perspective d'un dissipateur thermique comportant une paroi contre laquelle est fixé un composant électronique;
- la figure 2 représente un mode de fixation connu d'un composant contre un dissipateur thermique;
- la figure 3 est une vue en perspective d'un élément de fixation, selon un mode de réalisation préférentiel de l'invention;
- la figure 4 est une vue de face de l'élément de fixation de la figure 3;
- la figure 5 est une vue de côté de l'élément de fixation des figures 3 et 4;
- la figure 6 représente la fixation d'une pièce contre une paroi à l'aide d'un élément de fixation de l'invention.
- la figure 7 montre la fixation d'un composant électronique contre une paroi latérale d'un dissipateur thermique à l'aide de l'élément de fixation des figures 3 à 5;
- la figure 8 est une vue de côté schématique du dispositif de la figure 7;
- la figure 9 représente un autre mode de fixation d'un composant électronique contre une paroi d'un dissipateur thermique.

Les figures 1 et 2 ont été décrites précédemment en référence à l'état de la technique.

La figure 3 est une vue en perspective d'un élément de fixation, selon un mode de réalisation préférentiel de l'invention.

L'élément 30 de fixation représenté est constitué de deux branches d'extrémité 31,32 formant des tétons destinés à être engagés dans un ou deux logements pratiqués dans un dissipateur thermique. Les branches d'extrémité 31,32 sont chacune prolongées par une section d'élasticité 33,34 et 35,36 respectivement. Les sections d'élasticité 33,34 et 35,36 sont reliées par une section d'appui 37 destinée à entrer en contact avec le composant à maintenir contre le dissipateur thermique. L'élément 30 de fixation présente une symétrie par rapport à un axe XX passant entre les deux branches d'extrémité 31 et 32. Cet élément 30 de fixation est par exemple réalisé par pliage d'un fil d'acier dont le diamètre est de l'ordre de 1 mm. Ce fil d'acier présente un certain ressort, c'est à dire que la position de la section d'appui 37 par rapport aux branches d'extrémité 31,32 peut être modifiée sans que ceci entraîne une déformation irréversible des sections d'élasticité 33,34 et 35,36. Les branches d'extrémité 31 et 32 sont préférentiellement proches l'une de l'autre, comme il sera vu par la suite, afin de pouvoir être engagées dans un même logement.

Les figures 4 et 5 sont respectivement des vues de face et de côté de l'élément de fixation 30 de la figure 3.

Sur la figure 4, la distance d1 séparant les deux demi-branches 34 et 36 est destinée à permettre leur positionnement de part et d'autre d'un composant électronique, comme il sera vu dans la suite. Cette distance d1 est donc fonction de la largeur du composant électronique à fixer contre le dissipateur thermique.

Sur la figure 5, d2 correspond à la distance séparant la section d'appui 37 des branches d'extrémité 31 et 32. Cette distance est fonction de la position des logements de réception de ces branches d'extrémité par rapport à la paroi du dissipateur contre laquelle le composant devra être appliqué et de l'épaisseur de ce composant. La distance d3 correspond à la profondeur minimale des logements de réception des branches d'extrémité. Les demi-branches 33 et 35 font chacune un angle α avec les demi-branches 34 et 36, par exemple de l'ordre de 5°.

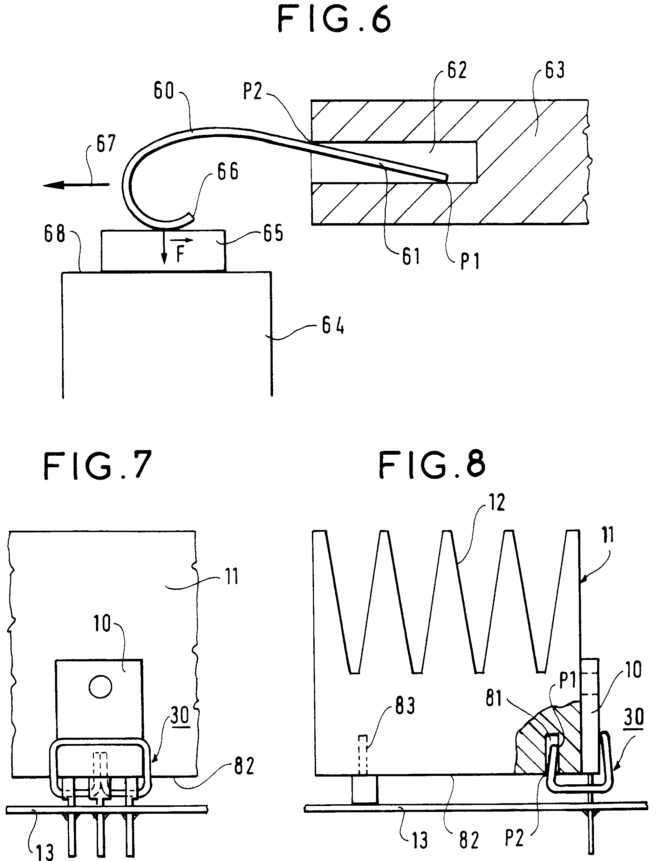

La figure 6 permet de comprendre le principe physique auquel la présente invention fait appel. Un élément de fixation 60, par exemple constitué par une lame métallique élastique, comporte une branche d'extrémité 61 engagée dans un logement 62 réalisé dans un élément 63 fixe par rapport à un support 64 d'une pièce 65. L'élément 63 et le support 64 sont donc solidaires l'un de l'autre. L'autre branche d'extrémité 66 de l'élément de fixation 60 est en appui contre la pièce 65 et maintient de ce fait la pièce 65 contre la surface supérieure 68 du support 64. La branche d'extrémité 66 constitue ainsi une section d'appui. Une force 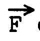 est appliquée par l'élément de fixation 60 sur la pièce 65 et la branche d'extrémité 61 est arc-boutée dans le logement 62.

Plus précisément, la branche d'extrémité 61 est en contact avec deux parois internes opposées du logement 62, en des points P1 et P2. Le point P1 est un point de contact de la branche d'extrémité 61 à l'intérieur du logement 62, situé du côté de la pièce 65, et le point de contact P2 un point situé à l'orifice du logement 62, de l'autre côté du logement 62 par rapport au point P1. Lorsque la pièce 65 doit être désolidarisée du support 64, la partie centrale de l'élément 60 est soulevée manuellement et la pièce 65 peut alors être enlevée. Lorsque l'élément de fixation 60 est relâché, la branche d'extrémité n'est plus en contact avec le point P2 (il n'y a plus d'arc-boutement de la branche d'extrémité 61 dans le logement 62) et l'élément de fixation 60 peut alors être retiré axialement du logement 62 selon une direction 67. Dans cette figure, la force 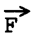 appliquée est perpendiculaire à la direction principale du logement 62. Il est à noter que ce mode de fixation requiert des efforts et des réactions qui ne sont pas dirigées selon la direction 67, contrairement à l'état de la technique le plus proche constitué par le dispositif de la figure 2 où une force opposée à 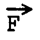 est appliquée au clip 20.

Afin d'assurer une force 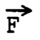 d'appui suffisante sur la pièce 65, il est préférable que l'élément de fixation 60 présente une longueur réduite, c'est à dire que le logement 62 soit proche de l'emplacement de la pièce 65.

Dans la présente invention, ce principe est appliqué à la fixation d'un composant électronique dissipant une énergie calorifique contre une paroi d'un dissipateur thermique.

La figure 7 montre la fixation d'un composant électronique contre une paroi d'un dissipateur thermique à l'aide de l'élément de fixation des figures 3 à 5 et la figure 8 une vue de côté schématique de l'ensemble.

Le composant électronique 10 est appliqué contre la paroi latérale 11 d'un dissipateur thermique 12 à l'aide de l'élément de fixation 30. La section d'appui de l'élément 30 est en contact avec la face avant du composant 10 et les sections d'élasticité passent de part et d'autre du composant pour rejoindre les deux branches d'extrémité. La pression s'exerce selon une direction sensiblement normale à la face avant du composant 10. Les branches d'extrémité sont engagées dans un logement commun 81 réalisé dans une paroi 82 contiguë à la paroi 11. Cette paroi constitue le dessous du dissipateur 12. Le logement 81 est par exemple un alésage ou un trou percé parallèlement à la paroi 11, de section circulaire et de diamètre supérieur ou égal à la somme des diamètres des branches d'extrémité de l'élément de fixation 30.

D'autres alésages 83, appelés alésages de fixation, sont réalisés dans la paroi 82. Ces alésages de fixation 83 reçoivent des vis de fixation du dissipateur 12 sur un circuit imprimé 13 sur lequel les pattes du composant 10 sont soudées. Une seule direction d'usinage du dissipateur 12 est alors nécessitée. Dans ce mode de réalisation, le composant 10 est appliqué par l'élément 30 contre le dissipateur 12 avant que ce dissipateur 12 ne soit fixé sur le circuit imprimé 13 et les pattes du composant 10 soudées. Bien entendu, les branches d'extrémité de l'élément 30 peuvent être chacune engagée dans un alésage dédié, mais il est alors nécessaire d'effectuer deux perçages de la paroi 82 pour le maintien de cet élément 30. Lorsque le diamètre de l'alésage 81 est égal à la somme des diamètres des branches d'extrémité, ou lorsque chaque alésage de réception d'une branche d'extrémité a un diamètre égal à celui d'une branche d'extrémité, l'insertion des branches d'extrémité s'effectue par simple pression manuelle et l'élément 30 ne retombe pas par gravité, du fait des frottements exercés à l'intérieur des alésages avant l'introduction d'un composant entre la section d'appui et la paroi 11. Un tel maintien peut également être assuré par un éloignement élastique des branches d'extrémité à l'intérieur d'un ou de deux logements, si dans une position de repos de l'élément 30 une distance est respectée entre ses branches d'extrémité. Ceci permet de monter des éléments de fixation sur un dissipateur et de déplacer le dissipateur sans que les éléments de fixation ne s'extraient par gravité, par exemple suite à des chocs ou des vibrations.

L'élasticité des sections d'élasticité est calculée pour assurer une pression importante sur le composant 10, de l'ordre de 15 kg, lorsque les branches d'extrémité sont en arc-boutement dans l'alésage 81.

Afin d'assurer une isolation électrique entre le composant électronique 10 et le dissipateur 11, une gaine électriquement isolante et thermiquement conductrice peut être enfilée sur le composant 10 avant sa fixation contre le dissipateur 12. Cette gaine est de type connu et par exemple en capton ou en SILPAD 400 (marque protégée).

L'élément de fixation 30 est préférentiellement constitué par un fil en acier à ressort fortement chargé en carbone, lui conférant une bonne résistance mécanique.

Bien entendu, d'autres modes de réalisation sont possibles et le fil peut également être d'un autre matériau, de section différente (carrée, rectangulaire,...) et de forme plus complexe (pliage différent).

Un autre avantage de l'invention est que l'alésage réalisé ne nécessite qu'un enlèvement de matière réduit. Il est en effet important de conserver autant que possible le chemin thermique originel du dissipateur intact, c'est à dire réduire le nombre et la taille des logements réalisés pour la fixation des éléments de fixation, sans quoi la qualité de la dissipation thermique diminue.

Le dissipateur thermique peut également être remplacé par un drain thermique destiné à véhiculer l'énergie calorifique vers un dissipateur.

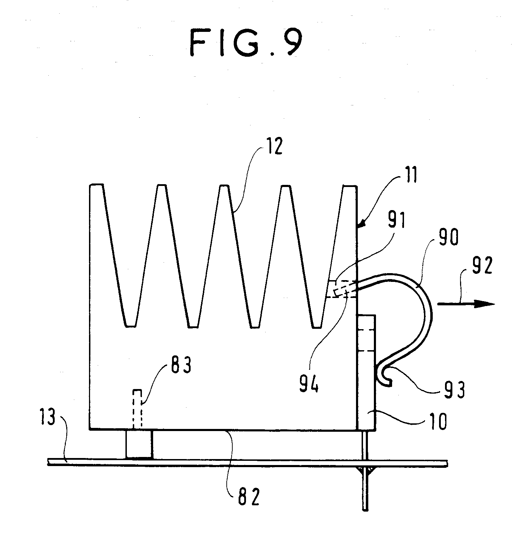

La figure 9 représente un autre mode de fixation d'un composant électronique contre une paroi de dissipateur thermique.

L'élément de fixation 90 comporte une branche d'extrémité 94 engagée dans un logement 91 ménagé dans la paroi latérale 11 du dissipateur thermique 12. La section d'appui est ici constituée par l'autre extrémité 93 de l'élément 90 de fixation, la section intermédiaire constituant la section d'élasticité. Plusieurs modes de réalisation sont possibles:
- l'élément de fixation 90 peut être constitué par une lame élastique de section parallélépipédique et dans ce cas le logement 91 est également de forme parallélépipédique. Ce logement peut par exemple être réalisé par perçage de deux alésages contigus.
- l'élément de fixation 90 peut également être constitué par un fil d'acier à ressort du type représenté aux figures 3 à 5, avec une forme convenable (sensiblement en L) pour fixer un composant contre une paroi dans laquelle le logement de réception de l'élément est ménagé. Ce logement 91 peut alors être constitué par un ou deux alésages, comme précédemment décrit en référence aux figures 7 et 8.

L'essentiel est qu'un arc-boutement de (des) extrémité(s) de l'élément de fixation soit obtenu dans le (les) logement(s) de réception des branches d'extrémité.

Le seul inconvénient de ce mode de fixation par rapport au précédent (fig.7 et 8) est qu'il est nécessaire d'effectuer des perçages du dissipateur 12 dans deux faces différentes, puisque plusieurs perçages de la face 82 sont nécessaires pour la fixation du dissipateur 12 sur le circuit imprimé 13. Il faut également veiller à ce que l'alésage 91, et donc l'ailette d'extrémité dans laquelle cet alésage est réalisé, soit suffisamment profond pour maintenir l'élément de fixation. Cependant, l'alésage 91 n'est pas obligatoirement réalisé au-dessus du composant 10, l'essentiel étant qu'il ne soit pas trop éloigné de ce composant pour limiter la longueur de l'élément de fixation 90 et permette ainsi d'exercer une pression suffisante sur le composant, et peut donc se situer dans une partie plus épaisse du dissipateur, notamment au niveau du composant 10.

Ce mode de réalisation présente cependant l'avantage de permettre une extraction très rapide et simplifiée de l'élément de fixation puisqu'il suffit de retirer axialement, c'est à dire selon une direction 92, cet élément pour libérer le composant 10.

Le dispositif de fixation de l'invention présente de nombreux avantages par rapport aux dispositifs existants:
- sa structure est simple et sa solidarisation au dissipateur thermique peut s'effectuer à l'aide d'un simple alésage réalisé dans le dissipateur, cet alésage pouvant s'effectuer parallèlement à d'autres alésages qu'il faut de toutes manières réaliser pour permettre la fixation du dissipateur sur un support, par exemple sur un circuit imprimé;
- l'alésage réalisé ne limite aucunement la qualité de la dissipation thermique, du fait d'un enlèvement de matière réduit;
- la fixation d'un composant est aisée et sa libération de même, puisqu'elle peut être effectuée axialement.

## Revendications

1. Dispositif de fixation d'un composant électronique (10) contre une première paroi (11) d'un dissipateur thermique (12), du type comprenant un élément de fixation (30) constitué par :
- au moins une branche d'extrémité (31, 32, 94) engagée dans au moins un logement (81, 91) réalisé dans une seconde paroi (82, 11) dudit dissipateur thermique (12), à proximité dudit composant (10);
- une section d'appui (37, 93) opposée à ladite branche d'extrémité au moins (31, 32, 94) et destinée à venir en appui contre la face avant dudit composant (10) dont la face arrière est plaquée contre ladite première paroi (11), ladite section d'appui (37, 93) étant reliée à ladite branche d'extrémité au moins (31, 32, 94) par une section d'élasticité (34, 36) de façon telle que s'exerce une poussée sur ladite face avant dudit composant (10) pour appliquer ledit composant (10) contre ladite première paroi (11),
caractérisé en ce que ladite branche d'extrémité au moins (31, 32, 94) peut s'engager sensiblement librement dans ledit logement (81, 91) selon une direction perpendiculaire à ladite seconde paroi (82, 11) et est maintenue par arc-boutement dans ledit logement (81, 91) lorsque ladite section d'appui (37, 93) applique ledit composant (10) contre ladite première paroi (11).

2. Dispositif selon la revendication 1, caractérisé en ce que chacun desdits logements (81, 91) est constitué par un trou percé dans ladite seconde paroi (82, 11).

3. Dispositif selon la revendication 1, caractérisé en ce que ladite seconde paroi (82) est la paroi constituant le dessous dudit dissipateur thermique (12), ladite première paroi (11) étant une des parois latérales dudit dissipateur thermique (12), ladite seconde paroi (82) comportant des alésages de fixation (83) destinés à permettre la fixation dudit dissipateur (12) sur un circuit imprimé (13), lesdits alésages de fixation (83) étant réalisés selon une direction de perçage parallèle à celle desdits logements (31, 32, 94).

4. Dispositif selon la revendication 1, caractérisé en ce que lesdits logements (31, 32, 94) sont réalisés dans ladite première paroi (11).

5. Dispositif selon l'une des revendications 1 à 4, caractérisé en ce que ledit élément de fixation (30) est constitué par un fil d'acier à ressort, la partie située au centre dudit fil d'acier à ressort constituant ladite section d'appui (37).

6. Dispositif selon la revendication 5, caractérisé en ce que ledit fil d'acier à ressort est de section circulaire.

7. Dispositif selon l'une des revendications 1 à 6, caractérisé en ce que ledit logement (31, 32, 94) est unique, de forme sensiblement parallélépipédique et réalisé dans ladite seconde paroi (82, 11), ledit élément de fixation (30) étant constitué par une lame ressort dont une extrémité pénètre dans ledit logement (31, 32, 94) sensiblement parallélépipédique.

8. Dispositif selon l'une des revendications 1 à 7, caractérisé en ce que ledit composant électronique (10) est engagé dans une gaine électriquement isolante et thermiquement conductrice avant son application contre ladite première paroi (11) par ledit élément de fixation (30).
